(19) Europäisches Patentamt
European Patent Office
Office européen des brevets

(11) EP 0 603 358 B1

(12) **EUROPEAN PATENT SPECIFICATION**

(45) Date of publication and mention of the grant of the patent:
**16.08.2000 Bulletin 2000/33**

(21) Application number: **93913582.8**

(22) Date of filing: **25.06.1993**

(51) Int. Cl.$^7$: **H01L 21/324**, H01L 21/322

(86) International application number:
**PCT/JP93/00865**

(87) International publication number:
**WO 94/00872 (06.01.1994 Gazette 1994/02)**

(54) **THERMAL TREATMENT OF A SEMICONDUCTOR WAFER**
WÄRMEBEHANDLUNG EINER HALBLEITERSCHEIBE
TRAITEMENT THERMIQUE D'UNE PLAQUETTE DE SEMI-CONDUCTEUR

(84) Designated Contracting States:
**AT BE CH DE DK ES FR GB GR IE IT LI LU MC NL PT SE**

(30) Priority: **29.06.1992 JP 19657692**

(43) Date of publication of application:
**29.06.1994 Bulletin 1994/26**

(73) Proprietor:
**SUMITOMO METAL INDUSTRIES, LTD.**
**Osaka (JP)**

(72) Inventors:
- **HORAI, Masataka**
  **1616-1, Yaemizo**
  **Saga-shi Saga 849 (JP)**
- **ADACHI, Naoshi**
  **1634-89, Hataketa**
  **Ogi-cho**
  **Saga 845 (JP)**
- **NISHIKAWA, Hideshi**
  **Saga 846 (JP)**
- **SANO, Masakazu**
  **Saga 840 (JP)**

(74) Representative:
**Hübner, Hans-Joachim, Dipl.-Ing.**
**Vonnemann, Kloiber, Lewald, Hübner**
**Edison Strasse 2**
**87437 Kempten (DE)**

(56) References cited:
**EP-A- 0 131 717** **DE-A- 3 142 589**

- **PATENT ABSTRACTS OF JAPAN vol. 016, no. 469 (E-1271)29 September 1992 & JP,A,4 167433 (TOSHIBA CORP) 15 June 1992**
- **PATENT ABSTRACTS OF JAPAN vol. 10, no. 347 (E-457)(2403) 21 November 1986 & JP,A,61 150340 (FUJITSU LTD) 9 July 1986**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 603 358 B1

## Description

### Technical Field

The present invention relates to a method of manufacturing a semiconductor wafer such as silicon and the like, particularly, it relates to a method of manufacturing a semiconductor wafer capable of improving characteristics and yields of a semiconductor element remarkably, by improving the crystal quality in the vicinity of the wafer surface, which is an active region of the semiconductor element.

### Background Art

A basic structure of a MOS-type large-scale integrated device such as an LSI, VLSI and the like is constituted by a MOS-type transistor and a MOS-type capacitor and so on, and in a gate portion of the transistor, a thin thermal oxidation film (gate oxidation Film) of several hundreds Å grown by thermal oxidation of a silicon substrate is used.

Insulation pressure resistance characteristics of the gate oxidation film depends largely on the crystal quality in the vicinity of the silicon substrate surface being used, and the reliability and yields of the large-scale integrated device such as the LSI, VLSI and the like are largely affected.

As a method for solving such problems, for example, as shown in Japanese Patent Laid Open Application No. Sho 60-231365, 61-193456, 61-193458, 61-193459, 62-210627 and Hei 2-177542, a heat treatment technique of a semiconductor substrate in a hydrogen gas atmosphere has been proposed, whereby the silicon oxidation film and silicon oxidation particles existing on the silicon substrate surface and oxygen deposits existing in the vicinity of the silicon substrate surface are eliminated by a hydrogen reduction effect, by heating the silicon substrate in a hydrogen atmosphere at 950°C to 1200°C for 5 minutes or longer.

When heating the silicon substrate in the hydrogen atmosphere, due to a very small amount of impurities in air such as oxygen and water mixed in the atmosphere, the silicon wafer surface becomes foggy and the micro-roughness may be deteriorated. Hereupon, the micro-roughness is defined as a fine surface roughness of several Å to several tens Å high.

Such deterioration of the micro-roughness is remarkably seen in an effective temperature range of the hydrogen atmospheric heat treatment, particularly, in a low temperature range of 950°C to 1050°C.

Such a problem was encountered that the GoI characteristics to be improved is, on the contrary, degraded due to the deterioration of the micro-roughness.

In the case of employing the hydrogen atmospheric heat treatment before a device process, a more effective high temperature range (1050°C to 1200°C) can be utilized to improve the crystal quality in the vicinity of the silicon surface.

This temperature range is advantageous in that a crystalline property of the silicon substrate is more improved, due to the outward diffusion of an oxygen impurity contained in a CS-Si substrate, besides the hydrogen reduction effect.

However, the electrically active impurities such as B and P also diffuse outwardly simultaneously and the resistivity increases near the surface, thus there is another problem that the desired resistivity can not be obtained.

It is an object of the present invention to provide a method of manufacturing a semiconductor wafer capable of solving such problems as deterioration of the micro-roughness in the low temperature range in the hydrogen atmospheric treatment and increase of resistivity due to the outward diffusion of the electrically active impurities in the high temperature range.

For the purpose of providing a method of manufacturing a semiconductor wafer which solves deterioration of the micro-roughness in a low temperature range in the hydrogen atmospheric treatment, and increase of resistivity in a high temperature range, as a result of various studies carried out on hydrogen atmospheric treatment conditions, the inventors have found that, in heat treatment in a hydrogen gas atmosphere, it is possible to suppress the reaction, in which a substrate surface is oxidized unequally and the micro-roughness is deteriorated, by bringing the concentration of gas molecules in air such as water, oxygen and the like below 5 ppm in equivalent water molecule concentration and furthermore, it is possible to prevent the outward diffusion of the impurity in the vicinity of the Si substrate surface to prevent variation of the resistivity by mixing the same kind of impurity gas as the electrically active impurity contained in the Si substrate into the atmosphere, and have completed the invention.

That is, the present invention is directed to a method of manufacturing a semiconductor wafer as claimed in claim 1.

Particularly described, is a method of manufacturing a semiconductor wafer, whereby a CZ-Si semiconductor substrate is heated in hydrogen gas atmosphere by using an epitaxial reaction furnace, a low pressure CVD furnace or the like, bringing gas molecules in air such as water, oxygen and the like below 5 ppm in equivalent water molecule concentration in the heat treating atmosphere for heat treatment.

The present invention proposes a method of manufacturing a semiconductor wafer by, in the above-mentioned configuration, mixing gas containing the same kind of impurity as the electrically active impurity contained in the semiconductor substrate being treated, into the heating atmosphere at a predetermined concentration.

It is possible for the present invention to annihilate Si dioxide particles existing on the CZ-Si substrate surface and fine oxygen precipitates existing in bulk in the vicinity of the CZ-Si substrate surface by hydrogen reduction, by the heat treatment in the hydrogen gas atmosphere.

Furthermore, by bringing the concentration of gas molecules in air such as water, oxygen and the like below 5 ppm in equivalent water molecule concentration in the heating atmosphere, a reaction in which the silicon substrate surface is reduced by hydrogen after being oxidized unequally, and the micro-roughness of the silicon substrate surface is deteriorated, can be suppressed.

Generally, a partial pressure P (atom) of an impurity in a gaseous phase which is in equilibrium state with a solid phase containing the volatile impurity at a concentration N (atoms/$cm^3$) at a certain temperature, is given by a following formula according to Henry's law.

$$N = H * p$$

where H is a constant determined by the temperature, and the kind of solid and impurity.

For example, in the case of a silicon single crystal, B in the silicon and $B_2O_3$ in the gaseous phase at 1100° C.

$H = 2 \times 10^{25}$ atoms($cm^3$ • atom)

Thus, since the outward diffusion or evaporation of the impurity in the vicinity of the silicon substrate surface is suppressed by a partial pressure of gas containing an electrically active impurity contained in the silicon substrate, for example, the same kind of impurity as P. B, As, Sb and the like, mixed with a partial pressure satisfying the aforementioned relationship at the heating temperature, variation of the resistivity in the vicinity of the silicon substrate surface can be prevented. In the present invention, though a method of bringing the concentration of water or oxygen molecules in air in the hydrogen atmospheric heat treatment below 5 ppm in equivalent water molecule concentration can be effected in any known heat treatment furnaces and is not particularly limited, for example, when using a general epitaxial reaction furnace, since it is subjected to an atmospheric release at the time of loading the semiconductor substrate, though there may be a fear of absorbing the water molecules, absorption of the water molecules at the time of atmospheric release can be suppressed by retaining the suscepter temperature at the time of placing the semiconductor substrate on a suscepter at 300°C or more, the water molecule absorption at the time of atmospheric release can be suppressed.

Also, in case of the furnace such as the epitaxial reaction furnace whose internal temperature prior to loading the substrate is 300°C or less from the room temperature, after placing the semiconductor substrate on a table such as the suscepter, atmospheric gas in the furnace is substituted by nitrogen gas, and while substituting further by hydrogen gas the temperature is raised to 750° C to 800° C, which is retained for 10 to 30 minutes to desorb and substitute the water molecules, thereafter the temperature is raised to a predetermined temperature to bring the water molecule and oxygen gas molecule concentration to 5 ppm or less in equivalent water molecule concentration. Furthermore, the hydrogen atmospheric heat treatment can also be effected in a furnace capable of $H_2$ treatment other than the epitaxial furnace such as a low pressure CVD furnace or the like, and in the case of the furnace whose internal temperature prior to loading the substrate is 300° C or more such as the vacuum CVD furnace, by the hydrogen gas substitution for a sufficient time after loading the Si wafer at the temperature of 300°C to 800°C in a nitrogen gas atmosphere the water molecule concentration in atmosphere can be brought to 5 ppm or less in equivalent water molecule concentration, without substantially causing the reaction with the Si wafer.

Fig. 1 is a graph showing the relationship between temperature and an intensity of irregular reflection light.

Fig. 2 is a graph showing the relationship between temperature and Gate oxide integrity yield.

Fig. 3 is a graph showing depth profile of .a B concentration from the surface.

In the following, the relationship between a micro-roughness and a water molecule concentration in the hydrogen atmospheric heat treatment is described according to the

Embodiment 1.

Mirror polished, (100) oriented CZ-Si single crystal wafer were heated for 10 minutes at four temperature of 1000°C, 1050°C, 1100°C and 1150°C in hydrogen gas atmospheres respectively containing water concentration of 0 ppm, 5 ppm, 10 ppm and 20 ppm.

For evaluation results of the micro-roughness of the Si wafer by using a laser particle counter are shown in Fig. 1. In Fig. 1, an ordinate shows a rate of intensity of irregular reflection light against an intensity of incident laser ray, in which the larger the value the larger the micro-roughness of the Si wafer surface. In Fig. 1 a symbol ● designates a water concentration of 0 ppm, a symbol ❍ designates a water concentration of 5 ppm, a symbol □ designates a water concentration of 10 ppm and a symbol △ designates a water concentration of 20 ppm.

From the results of Fig. 1, it has been confirmed that as the temperature decreases or as the water concentration increases the micro-roughness of the Si wafer surface is deteriorated. Also, in the case of mixing a small amount of oxygen in place of water, since water is produced by a reaction with hydrogen, similarly, deterioration of the micro-roughness occurs.

From the fact mentioned above, by lowering the water or oxygen concentration in the heating hydrogen atmosphere to 5 ppm or less in equivalent water molecule concentration, the deterioration of the micro-roughness in the low temperature range can be prevented.

Embodiment 2

In the following, the relationship between the micro-roughness of the silicon wafer surface and Gate oxide integrity characteristics of a MOS diode is described according to the embodiment 2.

After forming a gate oxide film having the thickness of about 250 Å by heat oxidation of the silicon wafer treated in embodiment 1 at 950°C for 35 minutes in the dry oxygen, a Poly-Si film was deposited to about 4000 Å in the low pressure CVD furnace, and further, P was doped in the Poly-Si film in a $POCl_3$ atmosphere. The wafers were subjected to resist coat mask exposure, development and etching to form a Poly-Si gate electrode having an area of 8mm. A gate oxide integrity yield of the MOS diodes is shown in Fig. 2, when judging Good or failure, the MOS diode passing an electric current of 10 μA or more at an electric field strength of 8 Mv/cm or less was evaluated as failure.

In Fig. 2, it is clear that the silicon wafer whose deterioration of micro-roughness is remarkable in embodiment 1 has a low gate oxide integrity yield.

Thereby, it has been confirmed that the gate oxide integrity characteristics are degraded by the deterioration of the micro-roughness of the silicon wafer surface.

Furthermore, by decreasing the water or oxygen concentration in the heating hydrogen atmosphere to 5 ppm or less in equavilent water molecule concentration, the deterioration of the micro-roughness was prevented and the degradation of the gate oxide integrity characteristic could be prevented.

Embodiment 3

In the following, the outward diffusion (or evaporation) of the electrically active impurity in the vicinity of the silicon substrate surface by the hydrogen atmospheric heat treatment and a method for suppressing the same are described according to the embodiment 3.

B-doped (100) oriented CZ-Si substrates with a concentration of about $10^{15}$ atoms/$cm^3$ were heated for 120 minutes in a 100% hydrogen atmosphere and a hydrogen atmosphere containing 1,05 ppb of $B_2O_3$ at 1100°C. Results of B concentration by spreading resistance measurement in the direction of depth from the surface, after dividing the wafers into about 5 mm squares and angle polishing at an intersecting angle of 1°9″ with a mirror surface, are shown in Fig. 3.

From Fig. 3, it has been confirmed that, the B concentration is decreased in a region of about 2μm from the surface in the 100% hydrogen atmosphere (shown by a broken line in the figure), but in the case of treating in the atmosphere containing B (shown by a solid line in the figure), the outward diffusion (or evaporation) of the impurity has not occurred.

Embodiment 4

An example of the method for decreasing the water or oxygen molecule concentration in the atmosphere in hydrogen atmospheric heat treatment to 5 ppm or less is described according to embodiment 4.

The water molecule concentration was continuously measured by connecting an atmospheric mass spectrometer to a sampling port provided at a furnace exhaust portion.

As a heating furnace, a vertical-type epitaxial reaction furnace of 100/volume was used. After placing Si wafers on a carbon suspecter at a room temperature, a bell jar was closed and atmospheric gas in the furnace was substituted by about 100 l/min of $N_2$ gas in the furnace about 100 l/min of $H_2$ gas in 5 minutes. The water molecule concentration in the furnace at this stage was 5 ppm or less. Next, when the temperature was raised to 1000° C in about 20 minutes while introducing the $H_2$ gas at about 90 l/min, the water molecule concentration increases with the temperature rise, and after reaching the maximum value of about 20 ppm, decreases gradually, but it took more than 10 minutes to decrease below 5 ppm after reaching 1000°C.

The water molecules produced by the temperature rise are those stuck to the surface of the carbon suscepter and quartz bell jar which are the main furnace components, at atmospheric release, and desorbed therefrom by the temperature rise.

It becomes clear by a thermal desorption spectrosopy analysis that degassing desorption temperature from the carbon suscepter is between 50 to 250° C with the peak temperature at about 100° C.

It also became clear that the desorption amount is dependent on the atmospheric releasing time, and the longer the atmospheric releasing time the larger the desorption amount.

From the above facts, it is possible to suppress the water molecule absorption at the time of atmospheric release by retaining the suscepter temperature at 300°C when placing the wafer in the furnace.

When it is difficult to retain at 300°C , the water molecule concentration can also be kept below 5 ppm by a method, whereby the atmospheric releasing time is shortened as much as possible, and after raising the temperature to 750 to 800°C and desorbing and substituting the water molecules by retaining that temperature for 10 to 30 minutes, the temperature is raised to a desired heating temperature. In the above-mentioned retained temperature (750 to 800°C), though the water molecule concentration in the atmosphere exceeds 5 ppm, at this temperature, the Si wafer is covered with a natural oxide film and substantially no reaction proceeds with the $H_2$ and water molecules.

Also in the case of hydrogen atmospheric heat treatment by the low pressure CVD furnace or the like, it has been confirmed that the water molecule concentration in the atmosphere can be suppressed below 5 ppm without substantially causing the reaction with the Si wafer, by gas substitution for a sufficient time after loading the Si wafer at the temperature of, for example 600 to 800° C.

Industrial Field of Application

The present invention is effective in (1) preventing deterioration of micro-roughness produced at 950°C to 1050°C, and (2) preventing variations of the resistivity in the vicinity of the surface, by heating a silicon wafer in a hydrogen atmosphere, wherein atmospheric impurities such as water, oxygen and the like are below 5 ppm in equavilent water molecule concentration, or furthermore, the same kind of impurity gas as the electrically active impurity contained in a silicon substrate is contained at a predetermined concentration.

The present invention can be applied in heat treatment furnaces of any known configuration, and by improving crystal quality in the vicinity of the wafer surface which is an active region of semiconductor device, it is possible to improve characteristics and yields of the semiconductor device remarkably.

## Claims

1. A method of manufacturing a semiconductor wafer whererin a silicon semiconductor substrate surface is heat treated in a hydrogen atmosphere, comprising the following steps:

   a) providing a furnace having an internal temperature above room temperature (RT), but below RT + 3000 C;
   b) loading and placing the silicon substrate on a table in the furnace, followed by replacement of the atmosphere in the furnace with nitrogen gas;
   c) increasing the temperature in the furnace to 750-800°C and simultaneously replacing the nitrogen gas with hydrogen gas;
   d) retaining the temperature of step (c) for 10 to 30 minutes to desorb water molecules from the silicon surface; and
   e) increasing the temperature to 950-1200° C, thus reducing the oxygen and water molecule content of the hydrogen atmosphere to below 5ppm in equivalent water molecule concentration.

2. A method according to claim 1 wherein a gas containing an impurity which is also present as an electrically active impurity in the silicon substrate is added to the hydrogen atmosphere in step (e).

3. A method according to claim 2 wherein the electrically active impurity is one of P, B, As and Sb.

## Patentansprüche

1. Verfahren zur Herstellung von Halbleiter Wafern, bei dem eine Silikon - Halbleitersubstrat - Oberfläche in einer Wasserstoffatmosphäre wärmebehandelt wird, bestehend aus folgenden Schritten:

   a) bereitstellen eines Schmelzofens mit einer inneren Temperatur größer als Raumtemperatur (RT), aber geringer als RT + 300°C;
   b) beladen und positionieren des Silikonsubstrats auf einem Tisch im Schmelzofen, gefolgt vom Austausch der Atmosphäre im Schmelzofen mit Stickstoff Gas.
   c) erhöhen der Temperatur im Schmelzofen auf 750 - 800 °C und gleichzeitigem Ersatz des Stickstoff Gases mit Wasserstoff Gas;
   d) halten der Temperatur aus Schritt (C) für 10 bis 30 Minuten, um Wassermoleküle von der Silikonoberfläche zu verdampfen; und
   e) erhöhen der Temperatur auf 950 - 1200 °C, um den Sauerstoff- und Wassermolekül - Gehalt der Wasserstoffatmosphäre unter 5 ppm in äquivalenter Wassermolekülkonzentration zu reduzieren.

2. Verfahren nach Anspruch 1, bei dem ein Gas mit Verunreinigungen, welches ebenso als eine elektrisch aktive Verunreinigung im Silikonsubstrat vorhanden ist, zur Wasserstoffatmosphäre in Schritt (e) zugegeben wird.

3. Verfahren nach Anspruch 2, bei dem die elektrisch aktive Verunreinigung aus P, B, As und Sb besteht.

## Revendications

1. Procédé de fabrication d'une pastille semi-conductrice dans lequel une surface d'un substrat semi-conducteur au silicium est traitée par voie thermique dans une atmosphère d'hydrogène, comprenant les étapes suivantes:

   a) prévoir un four ayant une température interne supérieure à la température ambiante (RT), mais inférieure à RT + 300 °C;
   b) charger et placer le substrat de silicium sur une platine dans le four, opération suivie du remplacement de l'atmosphère du four par du gaz azote;

c) pousser la température régnant dans le four à 750-800 °C, en remplaçant simultanément le gaz azote par du gaz hydrogène;

d) maintenir la température de l'étape (c) pendant 10 à 30 minutes, de façon à provoquer la désorption de molécules d'eau de la surface de silicium, et

e) pousser la température à 950-1200 °C, en réduisant ainsi la teneur en oxygène et en molécules d'eau de l'atmosphère d'hydrogène, jusqu'à moins de 5 ppm en concentration équivalente de molécules d'eau.

**2.** Procédé selon la revendication 1, dans lequel un gaz contenant une impureté qui est également présente en tant qu'impureté électrochimiquement active dans le substrat de silicium est ajoutée à l'atmosphère d'hydrogène à l'étape (e).

**3.** Procédé selon la revendication 2, dans lequel l'impureté électrochimiquement active est une de ces substances: P. B, As et Sb.

Fig, I

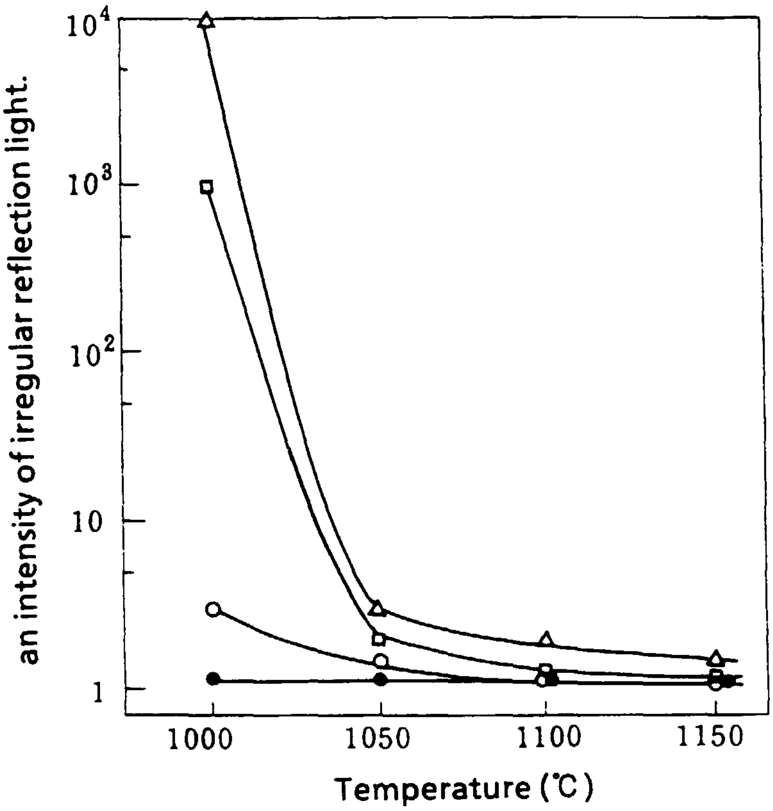

$10^4$
$10^3$
$10^2$
10
1
an intensity of irregular reflection light.
1000
1050
1100
1150
Temperature (℃)

Fig,2

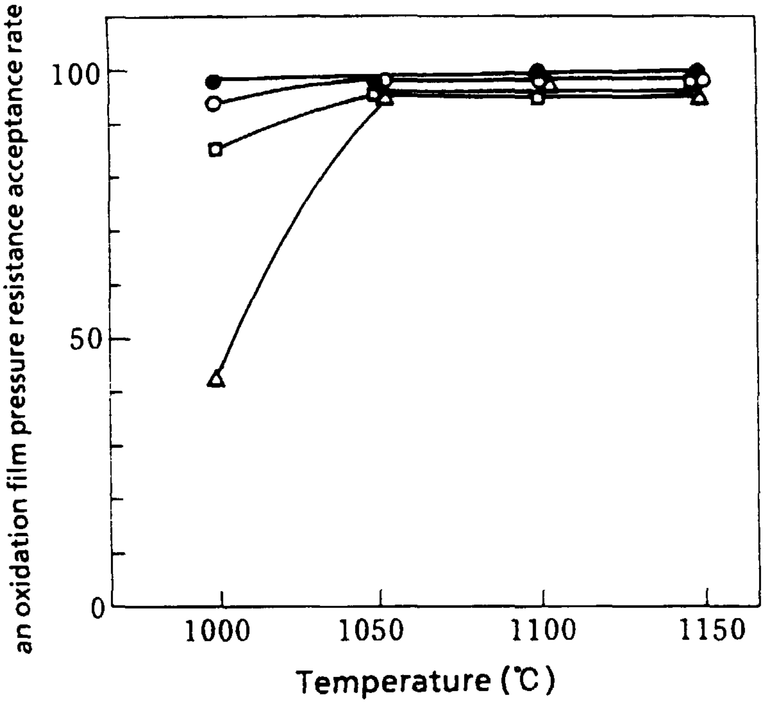
an oxidation film pressure resistance acceptance rate (%)
100
50
0
1000
1050
1100
1150
Temperature (℃)

Fig,3

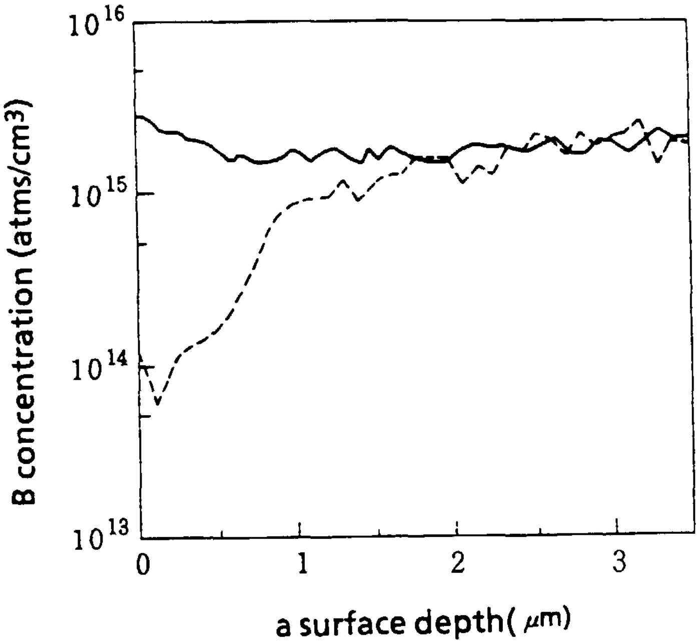
B concentration (atms/cm3)
$10^{16}$
$10^{15}$
$10^{14}$
$10^{13}$
0
1
2
3
a surface depth( μm)